# EUROPEAN PATENT APPLICATION

(11) **EP 0 587 889 A1**
(43) Date of publication of application: **23.03.1994**
(21) Application number: 92910166.5
(22) Date of filing: 13.05.1992
(51) Int. Cl.: H01L 21/304, H01L 21/306, H01L 21/00

(54) **METHOD FOR CLEANING AND APPARATUS THEREOF**

(30) Priority: 31.05.1991 JP 157654/91
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9200607
(87) International publication number: WO9222087

(57) **Abstract**

A method for cleaning an object and an apparatus therefor, which uses a substance alternative to chlorofluorocarbon and having a detergency equal to that of chlorofluorocarbon. When a pure water including ozone (e.g., a concentration of 1.5 ppm) is sprayed on the object (6) to be treated, extraneous substances adhering on the object are removed completely from the object by the oxidation by ozone.

## Description

### Technological Field

The present invention relates to a method for cleaning and apparatus thereof which can be completely removed extraneous substances adhering to objects such as semiconductor wafers.

### Background Art

Heretofore, in case of cleaning objects (i.e., semiconductor wafers), means has been carried out in a final treatment process, such as pouring pure water on the objects or spraying "triclane" (a trade name) type solution containing predetermined chemicals in pure water on the objects and so on.

However, it is difficult to remove oil component adhered to the objects completely, and in the present, it is impossible to remove mono-molecular layer oil as well.

It is conceived to use chlorofluorocarbon solution for removing such oil component. However, although the chlorofluorocarbon solution has excellently powerful cleaning force, it become cause of global environment pollution, that is to say ozonosphere destruction. Nowadays, its restriction is becoming more and more strict, therefor its positive use is undesirable.

The present invention seeks to solve the problem mentioned above, and its object is to provide a method for cleaning and apparatus thereof which can be completely removed extraneous substances without using chlorofluorocarbon solution.

### Disclosure of the Invention

In order to attain the above object of the present invention, a first gist is a method of cleaning, in which pure water containing ozone is sprayed to the objects.

A second gist of the present invention is an apparatus for cleaning, which comprises a nozzle, a pure water supply pipes for leading pure water from a pure water source to the nozzles, a pump for pumping out pure water, and a means for supplying ozone to pure water.

### Function

According to the present invention, pure water containing ozone is sprayed to the objects, and thus foreign substances, such as oil or the like, adhered to the objects can be removed completely by the powerful oxidizing action of ozone.

### Embodiment Examples

Next, embodiment examples for carrying out the invention will be described.

The ozone content is suitably 1 ppm or above. If the content is below 1 ppm, it may cause a failure of sufficient cleaning.

Further, the ozone content is preferably 1 to 5 ppm even if in the range of 1 ppm or above. If the ozone content is above 5 ppm, particles are introduced into pure water, and surface of the the objects may be roughed. This brings about serious influence especially in case the objects are semiconductor wafers. Further, by analyzing the particles, it was found they were composed of metal corrosion. Thus, it is thought the particles are introduced as a result of the inner surface of the the piping are corroded by ozone. If it is desired to let ozone be contained5 ppm or more, the inner surface of the piping may be polished by electrolytic composite polishing or the like, and then oxide passivation film may be formed by supplying high purity oxidizing gas(impurity concentration is several ppb or below), at a high temperature(400 to 500 °C). Moreover, a means for supplying ozone may be provided in the close proximity of the nozzle.

The pure water, which resistivity is more than 18 MΩ·cm or above in a normal temperature, is suitable to use in the present invention. Particularly, in case of cleaning semiconductor wafers, it is preferable to use pure water (i.e., ultra-pure water) with TOC of less than 1 ppb or below, a volatilization residue of 1 ppb or below and particle (more than 0.07 µm or above) population of 1 particle per ml.

It is suitable to spraying heated pure water to the object. The cleaning can be done quickly by spraying heated pure water. The heating temperature is suitably more than 60°C or above.

Further, it is possible to attain swift cleaning and high cleaning power by combining a process of spraying heated pure water and a process of spraying pure water at normal temperature. Although it is not clear why the swift cleaning and high cleaning power are attainable by combining the two steps, it is supposed that the temperature might have an influence on the ozone resolution.

Suitable pressure of the pure water when it is sprayed to the object is 30 kg/cm².

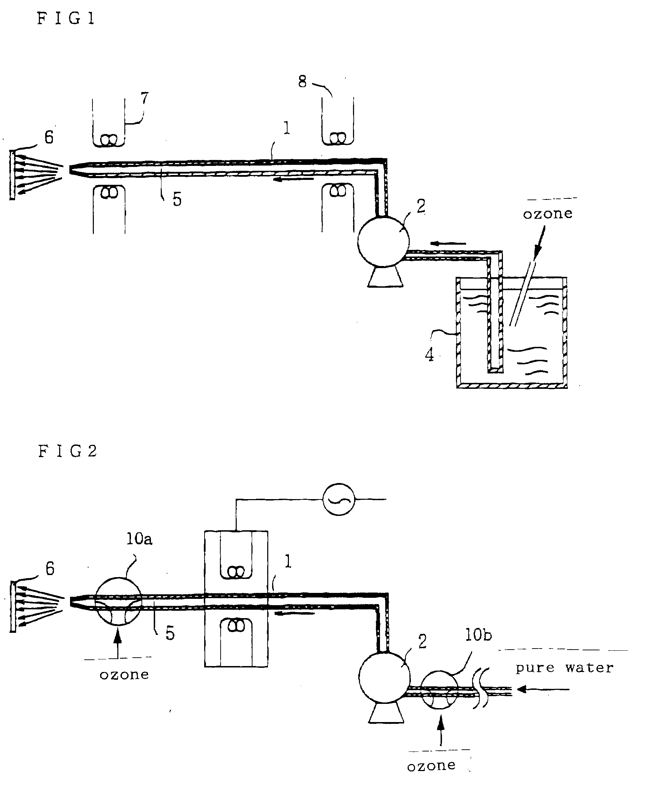

Next, the apparatus for cleaning in accordance with the present invention is described with reference to Fig. 1.

Fig. 1 shows the cleaning apparatus, which comprises a nozzle 9, a pure water supply pipe for leading pure water from a water tank 4 as pure water source to a nozzle 9, a pump 2 for pumping out pure water, and a means 10 for supplying ozone to the pure water.

Further details of the apparatus are described below.

The nozzle 9 may be composed as one with the pure water supply pipe 1 by reducing the diameter of one end of the pure water supply pipe 1. The other end of the pure water supply pipe 1 is connected to the outlet of a pump 2, and the suction port of the pump 2 is connected to the water tank 4.

Means for heating pure water is suitably provided at a appropriate position. As the means for heating pure water, heaters 7 and 8 may be used, and those heaters 7 and 8 may be disposed around the pure water supply pipes.

Moreover, it is possible to provided the cooling means in addition to the heating means. By providing the cooling means to cool the pure water, it is possible to control the temperature of the pure water in the pure water supply pipe in a short time.

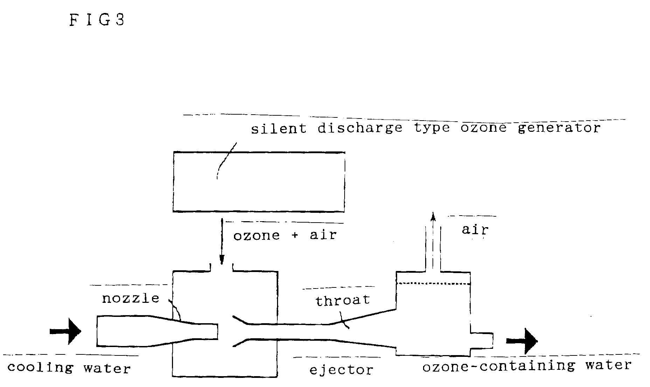

In the example shown in Fig. 1, although the means for supplying ozone to pure water is comprised by inserting a means for supplying ozone 10 in the pure water source 4, as shown in Fig. 2, ozone may be supplied in the intermediate portion of the pure water supply pipe 1 by connecting ejectors 10a and 10b (details are shown in Fig. 3) to the line. It is preferable to supply the ozone in the pure water supply pipe in view of accurate control of the concentration of ozone in the pure water sprayed on objects. Further, the ozone supply position is preferably provided to the downstream (i.e., as close to the nozzle 9) as much as possible. That is to say, in the example of Fig. 2, the ozone supply position is preferably provided at the position of 10b rather than 10a. Of course, it is possible to be provided at both positions.

Further, in order to supplying ozone in the pure water supply pipe, it is possible to use an aeration method or a film osmosis method besides the method like the connection of ejectors as shown in Fig. 2 and Fig. 3.

### Brief Description of the Drawings

Fig. 1 is a schematic sectional view showing an embodiment of the apparatus for cleaning according to the present invention;
Fig. 2 is a schematic sectional view showing a different embodiment of the apparatus for cleaning according to the present invention; and
Fig. 3 is a schematic view showing a means for supplying ozone.

### (Explanation of the references)

1: pure water supply pipe
2: pump (compressing pump)
3: pure water source (water tank)
6: object
7: means for heating pure water (heater)
8: means for heating pure water (heater)
9: nozzle
10: means for supplying ozone
10a: ejector
10b: ejector

### Best Mode for Carrying Out the Invention

### (Embodiment 1)

Cleaning of the object 6 is done by using the apparatus shown in Fig. 1. A semiconductor wafer adhering oil was used as the object, and the wafer was disposed such that it faced the outlet of the nozzle 9.

The ozone was introduced to the pure water (in this embodiment the resistivity of the pure water is 18 MΩ · cm) in the water tank 4 to become 3 ppm. Then the pure water was pumped from the water tank 4 by the pump 2 through the pure water supply pipe 1. And the pure water containing ozone is atomized and sprayed to the semiconductor wafer. At this time, the pure water was heated by the heaters 7 and 8 to 70 °C. The blow-out pressure was set to 40 g/cm². The ozone concentration in the pure water blown out from the nozzle 9 was measured and found to be 1.5 ppm.

Residual substances on the semiconductor wafer was checked after the cleaning, and no oil of mono-molecular layer was determined.

### (Embodiment 2)

In this embodiment, the pure water supply pipe 1 in which passivated film oxide was formed on the inner surface. The passivated film was formed as follows. The inner surface of the pure water supply pipe was polished by electrolytic polishing, and then the pure water supply pipe was heated in an oxidizing gas atmosphere (blended gas of Ar and oxygen) with an impurity concentration of 4 ppb or below and at 450 °C.

In this embodiment, ozone was supplied to the water tank 4 to set the ozone concentration to 6 ppm.

The ozone concentration in the pure water blown out from the nozzle 9 was 3 ppm, and cleaning power was superior to that in embodiment 1, and no roughening of the semiconductor wafer surface was recognized.

### (Embodiment 3)

In this example, the heaters 7 and 8 are turned on and off repeatedly to spray heated pure water and normal temperature pure water alternately to the object 6. For the rest, the embodiment was carried same as the previous Embodiment 1.

In this embodiment, the cleaning could be done in a short time compared to the Embodiment 1. In addition, cleaning effect was superior to that in the Embodiment 1.

### (Embodiment 4)

In this embodiment, the cleaning was done by using an apparatus with the ejector 10a provided near the nozzle 9 as shown in Fig. 2.

The ozone was supplied to the pure water in the pure water supply pipe 1 such that the ozone concentration in the pure water in the pure water supply pipe 1 was to become 2 ppm.

The ozone concentration in the pure water at the outlet of the nozzle 9 was 1.5 ppm.

High cleaning power were also shown in this embodiment.

### Industrial Applicability

According to the present invention described above, it is possible to remove foreign matters such as oil or the like adhering to the object completely even a mono-molecular layer of oil dose not remain.

Thus, it become possible to do cleaning, which is an important final process, in a highly clean state while avoiding the pollution problems at the semiconductor manufacturing or the like, by using ozone-containing water which is readily and inexpensively available as a substitute for the chlorofluorocarbon.

## Claims

1. A method of cleaning comprising the process of spraying ozone-containing pure water to the object.

2. The method of cleaning according to claim 1, wherein the content of said ozone is set to 1 ppm or above.

3. The method of cleaning according to claim 2, wherein the content of said ozone was set to 1 to 5 ppm.

4. The method of cleaning according to claim 1, wherein heated pure water is sprayed on the object.

5. The method of cleaning according to claim 1, which comprises the process of spraying heated pure water on the object and spraying normal temperature pure water on the object.

6. An apparatus for cleaning wherein are provided, a nozzle, a pure water supply pipe for leading the pure water from a pure water source to said nozzle, a pump for pumping out the pure water, and means for supplying ozone to the said pure water.

7. The apparatus for cleaning according to claim 6, which comprises means for heating pure water.

8. The apparatus for cleaning according to claim 6, wherein the said means for supplying ozone supplies the said pure water at the pure water source.

9. The apparatus for cleaning according to claim 6, wherein said means for supplying ozone supplies the said pure water in the said pure water supply pipe.

10. The apparatus for cleaning according to one of claims 6 through 9, wherein said pure water supply pipe is provided with passivated film oxide which is formed in an oxidizing gas atmosphere with an impurity concentration of several ppb or below at a temperature of 400 to 500 °C after the inner surface of the pipe is polished as a mirror surface by electrolytic polishing or the like.
